# EUROPEAN PATENT APPLICATION

(11) **EP 2 302 698 A2**
(43) Date of publication of application: **30.03.2011**
(21) Application number: 09180910.3
(22) Date of filing: 29.12.2009
(51) Int. Cl.: H01L 31/052

(54) **Photovoltaic concentrator and solar tracking device**

(30) Priority: 29.09.2009 TW 98217925 U
(71) Applicant: Everphoton Energy Corporation, Taipei 11493 (TW)
(72) Inventor: Chen, Yee Lee, 11493, TAIPEI (TW); Tsai, Chong Han, 11493, TAIPEI (TW)
(74) Representative: Collin, Jérôme

(57) **Abstract**

A power supply apparatus includes a first carrier and a second carrier connected with each other through a plurality of supporting rods, a plurality of light collecting units disposed on the second carrier, and an actuating rod group movably disposed on the first carrier. The light collecting units each have an upper portion pivotally connected to the second carrier and a lower portion pivotally connected to the actuating rod group. When the actuating rod group moves, the lower portion of each of the light collecting units swings about the upper portion with an amplitude corresponding to the position of the sun such that a lens assembly on each of the light collecting units faces the sunlight, thereby enhancing the light collecting efficiency.

## Description

### BACKGROUND OF THE INVENTION

### 1. Field of the Invention:

The present invention relates generally to photovoltaic device and power supply apparatus thereof.

### 2. Description of Related Art:

Since photovoltaic devices directly converse solar energy into electricity without generating any greenhouse gas or pollutant and provide safe power sources, they are helpful to reduce greenhouse gas emissions and provide stable energy supplies. Conventionally, a pillar is inserted into a foundation so as for a photovoltaic module to be disposed thereto. However, the construction of the foundation consumes a lot of time, area, effort and money. Meanwhile, the pillar is not suitable to be disposed on a roof.

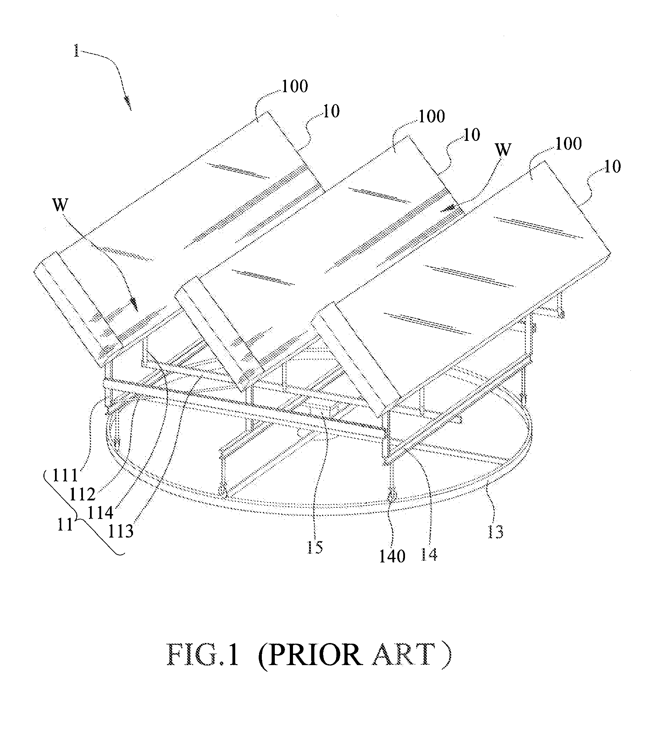

Accordingly, a module suitable to be disposed on the roof is developed. As shown in FIG. 1, a conventional photovoltaic device 1 comprises three photovoltaic modules 10 each provided thereon with a lens assembly 100, an actuating rod group 11 for supporting and actuating the photovoltaic modules 10, a circular track 13, a supporting member 14 for moving the photovoltaic module 10 along the track 13, and a detection actuating unit 15 for controlling operation of the actuating rod group 11 and the supporting member 14. As such, the photovoltaic device is suitable to be disposed on the roof, easy to assemble and meanwhile the construction of the foundation is dispensed with.

The actuating rod group 11 comprises pivot point rods 111, an active rod 112, coupling rods 114 and an assisting rod 113. The pivot point rods 111 are disposed at the bottom of the photovoltaic modules 10. The active rod 112 has one end thereof slidingly disposed on the rod body of the rear pivot point rod 111 and the other end thereof connected to the assisting rod 113. Further, the assisting rod 113 is connected to the coupling rods 114 that are connected to the lower portion of the lens assembly 100.

During operation of the photovoltaic device 1, the active rod 112 is moved upwards or downwards by the detection actuating unit 15 to thereby move the assisting rod 113 forwards or backwards, which further causes the coupling rods 114 to swing such that the lower portions of the photovoltaic modules 10 swing about the pivot rods 111, thereby adjusting the elevation of the lens assemblies 100. Further, solar the photovoltaic modules 10 can be turned eastwards or westwards corresponding to the path of the sun by controlling the operation of the supporting member 14 and the wheel train 140 of the supporting member 14 through the detection actuating unit 15.

However, in the conventional photovoltaic device 1, since the distance between the photovoltaic modules 10 is small, the front photovoltaic modules 10 may cast a shadow W on the rear photovoltaic module 10. Since the height of the sun in the four seasons of a year is different, the area of the shadow W is also different, which adversely affects the light collecting efficiency of the whole year. If the distance between the photovoltaic modules is increased to prevent the shadow W, the occupation area of the track 13 needs to be greatly increased according to the lowest height of the sun in the four seasons. As such, it is difficult for the device to be disposed on the roof.

Therefore, it is imperative to overcome the above drawbacks of the prior art.

### SUMMARY OF THE INVENTION

In view of the above drawback, the present invention provides a photovoltaic device and power supply apparatus thereof so as to enhance the light collecting efficiency. The power supply apparatus according to the present invention comprises: a first carrier functioning as a base; a second carrier disposed above the first carrier at an adjustable angle of inclination relative to the first carrier; a plurality of light collecting units disposed on the second carrier and each having a lens assembly, a solar cell module, first side portions being formed close to the lens assembly and second side portions being formed proximate to the first side portions, the first side portions being pivotally connected to the second carrier; and an actuating rod group comprising a plurality of coupling rods pivotally connected to the second side portions of the light collecting units, and an active rod capable of moving the coupling rods so as to enable the light collecting units to swing, thereby adjusting the elevation of the lens assemblies.

Therein, the second carrier has a plurality of pivot portions pivotally connected to the first side portions of the light collecting units, respectively. The power supply apparatus further comprises a plurality of supporting rods each having one end thereof pivotally connected to the first carrier and another end thereof disposed on the second carrier, wherein said another end is extended or retracted relative to said one end so as to adjust the angle of inclination of the second carrier with respect to the first carrier. In another embodiment, the actuating rod group further comprises an assisting rod connected to the active rod slidingly disposed on the first carrier. The active rod moves the assisting rod and the coupling rods so as to enable the second side portions of the light collecting units to swing. The actuating rod group further comprises a position limiting rod slidingly disposed on the first carrier for limiting the position of the assisting rod. The position limiting rod is connected between the first and second carriers and is capable of being extended or retracted so as for the length of the position limiting rod to be adjusted.

The light collecting units are arranged in at least one row and each has a casing for receiving the lens assembly and the solar cell module, the lens assembly being exposed from the casing and the solar cell module being located inside the casing and corresponding in position to the lens assembly such that solar radiation is focused on the solar cell module through the lens assembly.

The present invention further provides a photovoltaic device, which comprises: at least two above-described power supply apparatuses arranged in tandem; and a track rotatably supporting the first carriers so as to change the azimuth of the light collecting units corresponding to the path of the sun such that the sunlight falls on the lens assemblies at an optimum angle.

The track is of a circular shape. The first carrier further comprises a wheel train slidable and configured to move along the track. The first carrier is further provided with a supporting frame on which the wheel train is disposed. In addition, the first carrier can comprise a plurality of supporting members disposed between the supporting frame and the wheel train so as for the power supply apparatuses to slidingly move along the track.

According to the present invention, the actuating rod group causes the light collecting units to swing with an amplitude corresponding to the position of the sun so as for the lens assemblies to face the sunlight, thereby enhancing the light collecting efficiency. Further, the supporting rods can be adjusted to change the height of the second carrier corresponding to the height of the sun in the four seasons. Furthermore, the present invention prevents the front power supply apparatus from casting a shadow on the rear power supply apparatus without the need of increasing the distance therebetween and accordingly enhances the light collecting efficiency compared with the prior art.

### BRIEF DESCRIPTION OF DRAWINGS

FIG. 1 is a perspective view of a conventional photovoltaic device;
FIG. 2A is a perspective view of a power supply apparatus according to the present invention;
FIG. 2B is an exploded view of the power supply apparatus according to the present invention;
FIG. 3 is a perspective view of a light collecting unit of the power supply apparatus according to the present invention;
FIGS. 4A and 4B are operational views of an actuating rod group of the power supply apparatus according to the present invention;
FIGS. 5A and 5B are operational views of supporting rods of the power supply apparatus according to the present invention;
FIG. 6A is a perspective view of a photovoltaic device according to the present invention;
FIG. 6B is an azimuth definition diagram for the sun; and
FIG. 7 is a perspective view of a photovoltaic device according to another embodiment of the present invention.

### DETAILED DESCRIPTION OF PREFERRED EMBODIMENTS

The following illustrative embodiments are provided to illustrate the disclosure of the present invention, these and other advantages and effects can be apparent to those skilled in the art after reading the disclosure of this specification.

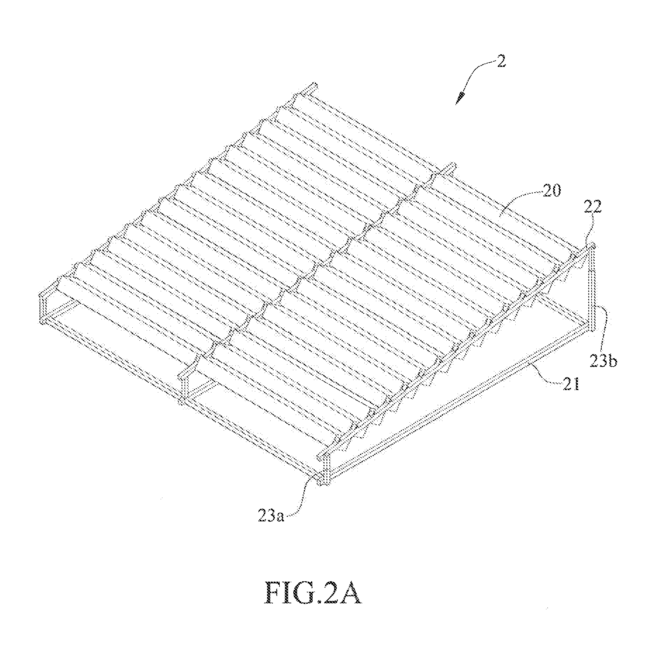

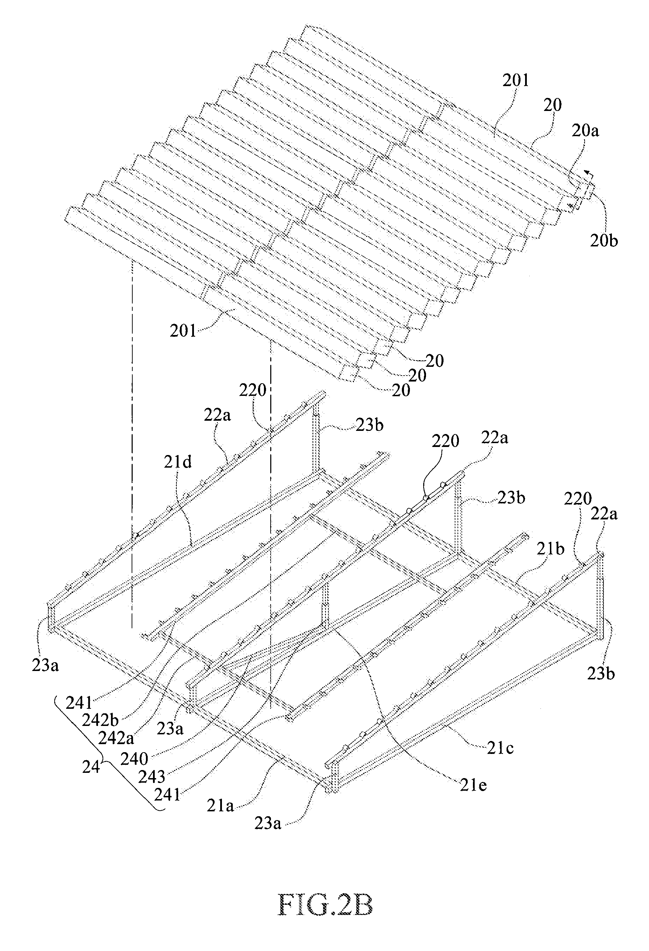

Referring to FIGS. 2A and 2B, a power supply apparatus 2 used for converting solar energy into electrical energy comprises: a first carrier 21, a second carrier 22, a plurality of supporting rods 23a, 23b connecting the first and second carriers 21, 22, a plurality of light collecting units 20 disposed on the second carrier 22, and at least an actuating rod group 24 for bringing the light collecting units 20 to swing.

The first carrier 21 comprises five portions 21a, 21b, 21c, 21d and 21e, which serves as the base of the power supply apparatus and is mounted on such as a roof. The second carrier 22 comprises three rods 22a and a plurality of pivot portions 220, which is disposed above the first carrier 21.

Three supporting rods 23a, 23b each have one end thereof connected to the first carrier 21 and another end thereof connected to the second carrier 22, wherein three supporting rods 23a and three supporting rods 23b are provided at the front and rear sides of the second carrier, respectively, such that the second carrier 22 is angularly disposed relative to the first carrier 21. The supporting rods 23a rotatably support the front side of the second carrier 22 and the height of the rear side of the second carrier 22 can be adjusted through the supporting rods 23b so as to adjust the distance between the first and second carriers 21, 22.

In the present embodiment, the supporting rods 23a each have one end thereof fixed in position to the first carrier 21 and another end thereof pivotally connected to the second carrier 22; and the supporting rods 23b each have one end thereof pivotally connected to the first carrier 21 and another end thereof slidingly disposed to the second carrier 22 so as to adjust the maximum distance between the first and second carriers 21, 22.

The light collecting units 20 are arranged on the second carrier 22 one behind another in a row. In the present embodiment, there are two rows of the light collecting units 20, but it is not limited thereto. The light collecting units 20 each have first side portions 20a and second side portions 20b. In the present embodiment, the first side potions 20a are located at the upper portion of the light collecting unit 20 and the second side portions 20b are located at the lower portion of the light collecting unit 20, and the first side portions 20a are pivotally connected to the pivot portions 220 of the second carrier 22, respectively.

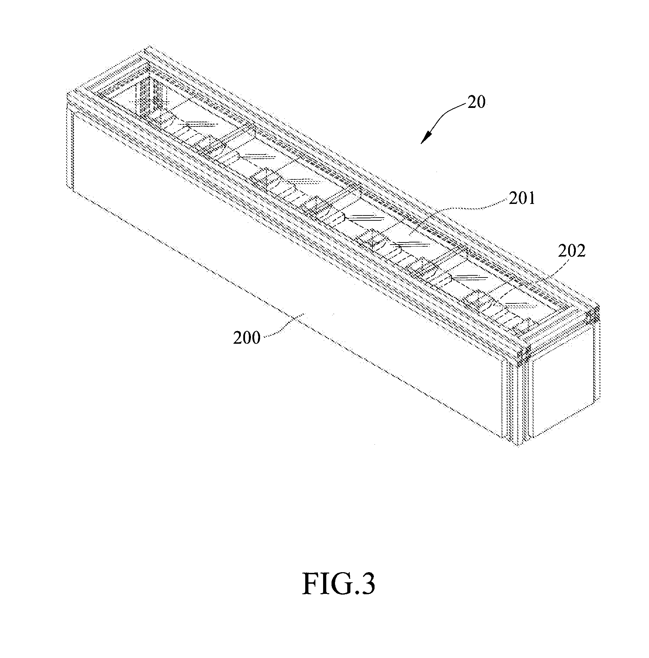

In particular, referring to FIG. 3, the light collecting units 20 each have a lens assembly 201, a solar cell module 202, and a casing 200 for receiving the lens assembly 201 and the solar cell module 202. The lens assembly 201 is disposed on the top of the casing 200 (at a sun-facing region between the two adjacent first side portions 20a) and exposed from the casing 200. The solar cell module 202 is disposed on the bottom of the casing 200 (at a region between the two adjacent second side portions 20b) to correspond in position to the lens assembly 201 such that solar radiation is focused on the solar cell module 202 through the lens assembly 201. But it should be noted that the structure of the light collecting units is not limited to the above embodiment.

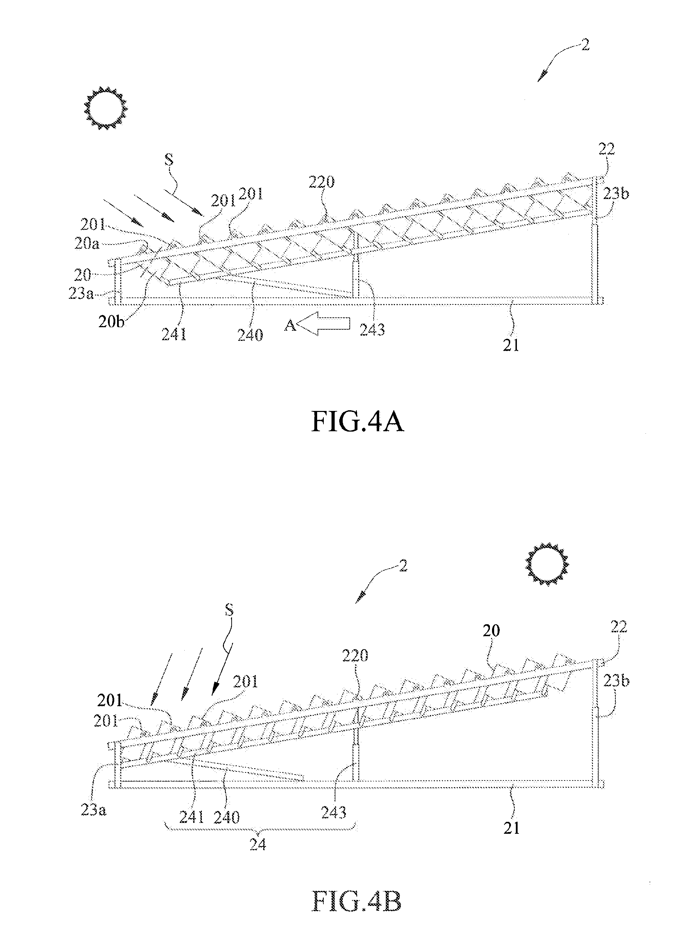

Referring to FIGS. 4A and 4B, the actuating rod group 24 is slidingly disposed on the first carrier 21 and pivotally connected to the second side portions 20b of the light collecting units 20. When the actuating rod group 24 moves on the first carrier 21, it brings the light collecting units 20 to swing.

In particular, the actuating rod group 24 has an active rod 240 and a plurality of coupling rods 241. The active rod 240 has one end thereof slidingly disposed on the first carrier 21 and the other end thereof fixed in position to the coupling rods 241. The coupling rods 241 are pivotally connected to the second side portions 20b of the whole row of the light collecting units 20. In the present embodiment, at least two coupling rods 241 are provided at the two sides of the light collecting units 20 so as to bring the light collecting units 20 to swing in a balanced manner. The actuating rod group 24 further comprises assisting rods 242a, 242b connected to the active rod 240 and the coupling rods 241 so as for the single active rod 240 to move the coupling rods 241. It should be noted that since there are various kinds of methods for slidingly disposing the active rod 240 to the first carrier 21 in the art, the drawings do not provide detailed illustration.

FIGS. 4A and 4B illustrate the operation of the actuating rod group 24 according to the present invention. When the active rod 240 is driven to move forward or backward, the coupling rods 241 are brought to move forward or backward together with the active rod 240, which further brings the second side portions 20b of the whole row of the light collecting units 20 to swing about the corresponding first side portions 20a, respectively, such that the whole row of the light collecting units 20 present a shutter style open/close effect. During operation, a detection actuating unit (not shown) is used to provide a drive force for operating the actuating rod group 24. Since the detection actuating unit is well known in the art and is not considered an essential technical feature of the present invention, detailed description thereof is omitted herein.

Table 1 shows the elevation and azimuth of the sun at latitude 23 degrees north at different time points. If the active rod 240 of the actuating rod group 24 moves towards a direction A, the lower portion of the light collecting units 20 can swing such that the elevation of the lens assemblies 201 is adjusted to correspond to the path of the sun in a day. For example, the swing amplitude of the light collecting units 20 is configured to correspond to the path of the sun from eight in the morning to four in the afternoon on January 21^{st} so as for the lens assembly 201 to face the sunlight S, thereby enhancing the light collecting efficiency of the power supply apparatus 2.

Further, a position limiting rod 243 is disposed in the path of movement of the active rod 240 so as to prevent the active rod 240 from sliding away from the efficient path, as shown in FIGS. 2B, 4A and 4B.

**Table 1**

| Latitude 23 degrees North, 21 st of Each Month | | | | | | | | | | |
|---|---|---|---|---|---|---|---|---|---|---|
| time | 08:00 | | 10:00 | | 12:00 | | 14:00 | | 16:00 | |
| date | azimuth | elevation | azimuth | elevation | azimuth | elevation | azimuth | elevation | azimuth | elevation |
| Jan | 148.4 | 17.3 | 126.5 | 37.9 | 90 | 46.9 | 53.5 | 37.9 | 31.6 | 17.3 |
| Feb | 156.4 | 22 | 133.8 | 44.9 | 90 | 55.8 | 46.2 | 44.9 | 23.6 | 22 |
| Mar | 166.9 | 27.2 | 145.4 | 52.6 | 90 | 55.5 | 34.6 | 52.6 | 13.1 | 27.2 |
| Apr | 179.6 | 31.9 | 163.3 | 59.2 | 90 | 78.6 | 16.7 | 59.2 | 0.4 | 31.9 |
| May | 189.3 | 34.5 | 179.9 | 62 | 90 | 87.1 | 0.1 | 62 | 350.7 | 34.5 |
| Jun | 193.2 | 35.3 | 187 | 62.5 | 270 | 89.6 | 353 | 62.5 | 346.8 | 35.3 |
| Jul | 189.4 | 34.5 | 180.1 | 62 | 90 | 87.2 | 359.9 | 62 | 350.6 | 34.5 |
| Aug | 179.4 | 31.9 | 163 | 59.2 | 90 | 78.4 | 17 | 59.2 | 0.6 | 31.9 |
| Sep | 166.7 | 27.1 | 145.2 | 52.5 | 90 | 66.4 | 34.8 | 52.5 | 13.3 | 27.1 |
| Oct | 155.6 | 21.6 | 143 | 44.2 | 90 | 54.9 | 47 | 44.2 | 24.4 | 21.6 |
| Nov | 147.8 | 16.9 | 126 | 37.3 | 90 | 46.2 | 54 | 37.3 | 32.2 | 16.9 |
| Dec | 145.6 | 15.5 | 124.2 | 35.2 | 90 | 43.6 | 55.8 | 35.3 | 34.4 | 15.5 |

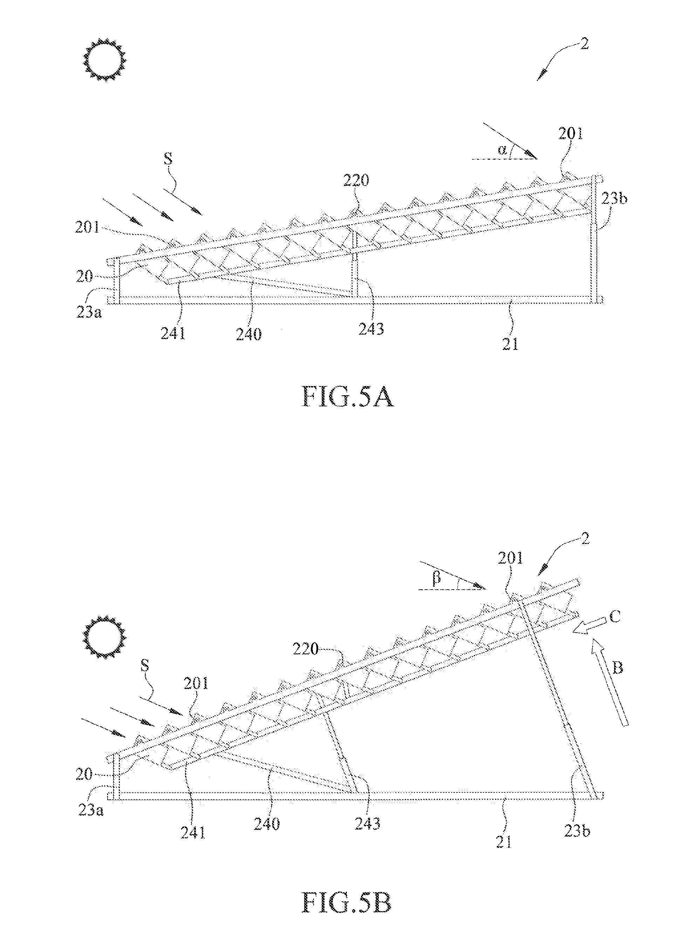

FIGS. 5A and 5B show the operation of the supporting rods 23a, 23b. The driving force is provided by a detection actuating unit (not shown) for controlling the extension and retraction movement of the supporting rods 23b. When the supporting rods 23b extends towards a direction B, the supporting rods 23b slide on the second carrier 22 towards a direction C, and the rear side of the second carrier 22 swings around the supporting rods 23a located at the front side of the second carrier 22 such that both the rear side of the second carrier 22 and the whole row of the light collecting unit 20 are lifted. On the other hand, the supporting rods 23b can be retracted and the position limiting rod 243 can undergo the same retraction movement as the supporting rods 23b.

Further referring to FIG. 2B, the assisting rod 242a is pivotally connected to the coupling rods 241, when the second carrier 22 is lifted or lowered, the coupling rods 241 is also lifted or lowered, that is, the assisting rod 242b swings about the assisting rod 242a so as to lift or lower the rear side of the coupling rods 241 while the position of the assisting rod 242a and the active rod 240 remain unchanged. It should be noted that since there are various kinds of methods for slidingly disposing the supporting rods 23b on the second carrier 22 in the art, the drawings do not provide detailed illustration.

Further referring to Table 1, the supporting rods 23b undergo extension or retraction movement so as for the light collecting units 20 to correspond to different elevations at the same time point of different seasons, for example, an elevation of 35.3 degree at eight in the morning of June and an elevation of 17.3 degree at eight in the morning of January. As such, the elevation of the lens assemblies 201 can be adjusted (for example, α, β, α>β in the drawings) to face the sunlight S so as for the power supply apparatus 2 to collect the same amount of sunlight at the same time point of different seasons.

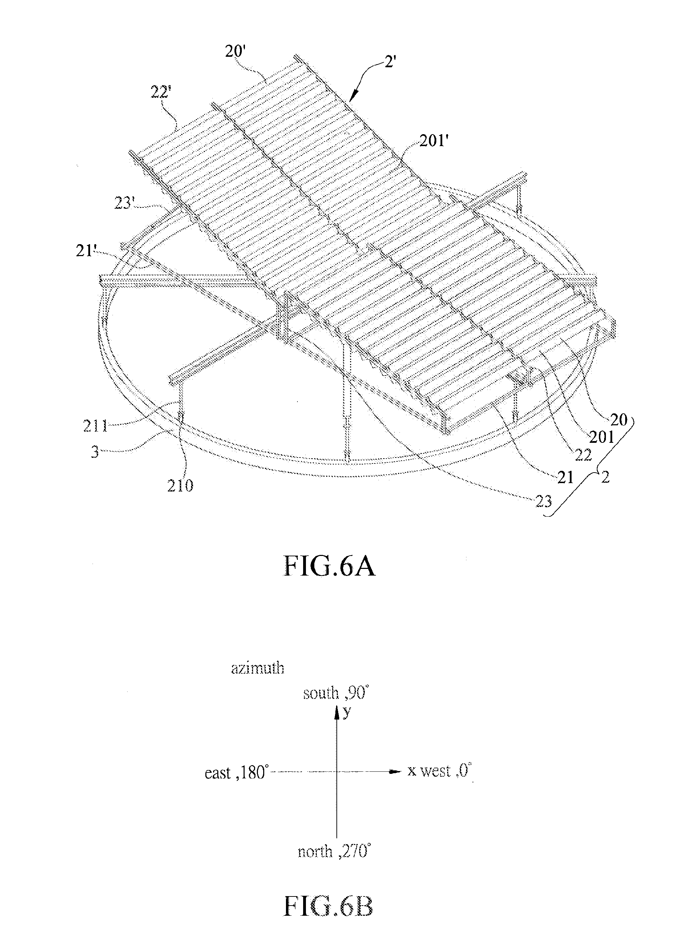

FIGS. 6A shows a photovoltaic device according to the present invention, and FIG. 6B is an azimuth definition diagram for the sun corresponding to Table 1. As shown in FIG. 6A, the photovoltaic device comprises: at least two power supply apparatuses 2, 2' arranged in tandem, a track 3 corresponding to the path of the sun, and a supporting frame 4 slidingly disposed on the track 3 and connected to the power supply apparatuses 2, 2'.

The two power supply apparatuses 2, 2' are the same as each other. In other embodiments, the number of the power supply apparatuses 2, 2' can be increased as needed. The first carriers 21, 21' have a wheel train 210 slidable and configured to move along the track 3. The first carriers 21, 21' further have supporting members 211 on which the wheel train 210 is disposed.

The track 3 is of a circular shape and is fixed in position to the ground. The track 3 can rotatably support the first carrier 21 so as to change the azimuth of the light collecting units20 on the second carrier 22 corresponding to the path of the sun such that the sunlight falls on the lens assemblies 201 at an optimum angle. In the present embodiment, the track 3 is fixed in position to the roof, and is of a circular shape corresponding to the azimuth of FIG. 6B. Alternatively, the track is of an irregular curved shape, a triangular shape, a rectangular shape or an elliptic shape.

The supporting frame 4 are of a radial shape, which has an upper end thereof fixed in position to the first carriers 21, 21' and a lower end with the supporting members 211 slidingly disposed on the track 3 such that the power supply apparatuses 2, 2' can slide along the track 3 so as to turn eastwards or westwards corresponding to the path of the sun of different seasons. The number of the wheel train 40 of the supporting frame 4 can be changed according to the configuration of the first carriers 21, 21' such that the power supply apparatuses can turn direction in a balanced manner. Further, the type of the supporting frame 4 is not limited to the present embodiment.

In the present embodiment, the rear side of the second carrier 22' of the power supply apparatus 2' can be lifted or lowered by extending or retracting the supporting rods 23' located at the rear side of the power supply apparatus 2' so as to make the light collecting units 20' of the power supply apparatus 2' correspond to the height of the sun in the four seasons as shown in FIGS. 5A and 5B. As such, the lens assembly 201' of the power supply apparatus 2' can absorb the needed sunlight. The prevent invention prevents the front power supply apparatus 2 from casting a shadow on part of the light collecting units 20' of the rear power supply apparatus 2' without increasing the distance between the power supply apparatuses 2, 2', thereby enhancing the light collecting efficiency in all the four seasons of a year. Furthermore, the supporting rods 23 located at the front side of the power supply apparatus 2 can be adjusted as needed.

During operation, the detection actuating unit (not shown) controls the supporting frame 4 and the supporting rods 23, 23' so as to adjust the direction of the power supply apparatuses 2, 2' corresponding to the sun and adjust the relative height of the second carriers 22, 22'.

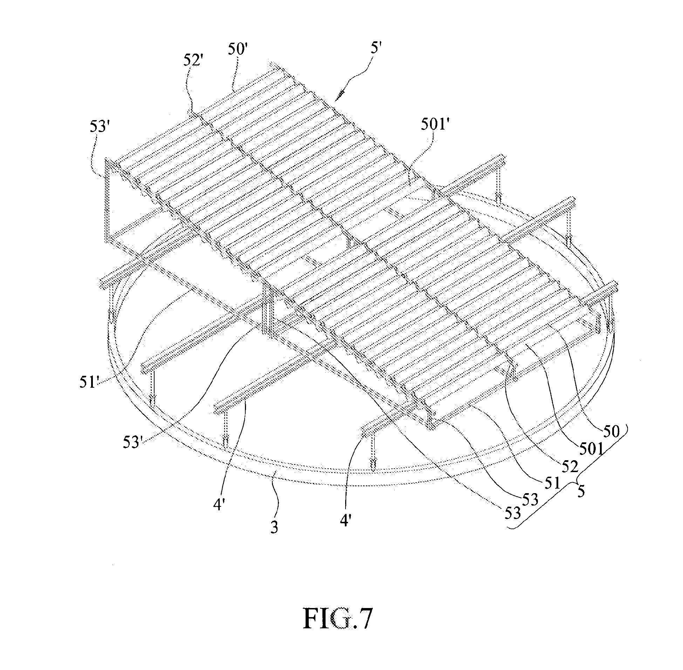

FIG. 7 shows another embodiment of a photovoltaic device. The photovoltaic device of the present embodiment is mostly similar to the first embodiment. The photovoltaic device of the present embodiment differs from that of the first embodiment in terms of design and operation of the supporting rods.

The supporting rods 53, 53' are disposed corresponding to the configuration of the second carriers 52, 52', with one end thereof fixed in position to the front and rear sides of the first carriers 51, 51' and the other end thereof fixed in position to the front and rear sides of the second carriers 52, 52' for synchronously lifting or lowering the front and rear sides of the second carriers 52, 52'. Further, the number of the supporting rods 53, 53' can be increased or decreased as needed.

By adjusting the supporting rods 53' at the rear side of the power supply apparatus 5' so as to increase the whole height of the second carrier 52' of the power supply apparatus 5' and moving the active rod 240 (referring to FIG. 2B) backwards or forwards, the light collecting units 50' of the rear power supply apparatus 5' can be higher than the light collecting units 50 of the front power supply apparatus 5. Thus, the lens assemblies 501' at the rear side together with the lens assemblies 501 at the front side form a solid plane so as to collect the sunlight at dawn and dusk.

Further, in the present embodiment, supporting frames 4' are parallel arranged.

In addition, corresponding to different height of the sun in different areas of different latitudes, the elevation of the device can be adjusted so as to collect required amount of light.

According to the present invention, the actuating rod group brings the whole row of light collecting units to swing with an amplitude corresponding to the position of the sun so as to make the lens assemblies face the sunlight, thereby enhancing the light collecting efficiency.

Further, the supporting rods can be adjusted to change the height of the second carrier so as to make the light collecting units correspond to the height of the sun in a year, thereby enhancing the light collecting efficiency.

The above-described descriptions of the detailed embodiments are intended to illustrate the preferred implementation of the present invention but are not intended to limit the scope of the present invention, Accordingly, all modifications and variations made to the embodiments by persons skilled in the art should still fall within the scope of present invention defined by the appended claims.

## Claims

1. A power supply apparatus, comprising:
a first carrier functioning as a base;
a second carrier disposed above the first carrier at an adjustable angle of inclination with respect to the first carrier;
a plurality of light collecting units disposed on the second carrier, each light collecting unit having a lens assembly, a solar cell module, first side portions being formed close to the lens assembly, and second side portions being formed proximate to the first side portions, the first side portions being pivotally connected to the second carrier; and
an actuating rod group comprising a plurality of coupling rods pivotally connected to the second side portions of the light collecting units, and an active rod capable of moving the coupling rods so as to enable the light collecting units to swing, thereby adjusting an elevation of the lens assemblies.

2. The power supply apparatus of claim 1, wherein the second carrier has a plurality of pivot portions pivotally connected to the first side portions of the light collecting units, respectively.

3. The power supply apparatus of claim 1, further comprising a plurality of supporting rods each having one end thereof pivotally connected to the first carrier and another end thereof disposed on the second carrier, wherein said another end is extended or retracted relative to said one end so as to adjust the angle of inclination of the second carrier with respect to the first carrier.

4. The power supply apparatus of claim 3, wherein the actuating rod group further comprises an assisting rod connected to the active rod slidingly disposed on the first carrier, the active rod moving the assisting rod and the coupling rods so as to enable the second side portions of the light collecting units to swing.

5. The power supply apparatus of claim 4, wherein the actuating rod group further comprises a position limiting rod slidingly disposed on the first carrier for limiting the position of the assisting rod, connected between the first and second carriers, and capable of being extended or retracted so as for a length of the position limiting rod to be adjusted.

6. The power supply apparatus of claim 1, wherein the light collecting units are arranged in at least one row.

7. The power supply apparatus of claim 1, further comprising a track for rotatably supporting the first carriers so as to change an azimuth of the light collecting units corresponding to the path of the sun such that the sunlight falls on the lens assemblies at an optimum angle.

8. The power supply apparatus of claim 7, wherein the first carrier is further provided with a wheel train slidable and configured to move along the track.

9. The power supply apparatus of claim 8, wherein the first carrier is further provided with a supporting frame on which the wheel train is disposed.

10. The power supply apparatus of claim 9, further comprising a plurality of supporting members disposed between the first carrier and the supporting frame so as for the light collecting units to slidingly move along the track by means of the supporting members.
